# EUROPEAN PATENT APPLICATION

(11) **EP 4 567 376 A1**
(43) Date of publication of application: **11.06.2025**
(21) Application number: 23849733.3
(22) Date of filing: 26.05.2023
(51) Int. Cl.: G01C 3/06

(54) **SENSOR, METHOD FOR MANUFACTURING SENSOR, AND INFORMATION PROCESSING METHOD**

(30) Priority: 03.08.2022 JP 2022124366
(71) Applicant: OSAKA UNIVERSITY, Suita-shi Osaka 565-0871 (JP)
(72) Inventor: KOYAMA, Keisuke, Suita-shi, Osaka 565-0871 (JP)
(74) Representative: Alpspitz IP
(86) International application number: PCT/JP2023/019693
(87) International publication number: WO 2024/029172

(57) **Abstract**

[Problem] To provide a high precision sensor having a simpler structure.

[Solution] According to one aspect of the present disclosure, a sensor for measuring objects is provided. The sensor comprises a plurality of light-emitting elements and at least one of light-receiving element(s). The light-emitting elements are each provided at a different position on a substrate. The light-receiving element is provided on the substrate. The light-receiving element receives, as main light, one reflected light from among reflected light attributed to each light-emitting element, and receives, as crosstalk light, reflected light other than the main light in a manner such that the crosstalk light can be distinguished from the main light. The reflected light is emitted from each of the light-emitting elements and reflected from an object. On the basis of the crosstalk light and main light that are received in a distinguishable manner, spatial physical quantities related to a reference plane of the sensor and the object are measured.

## Description

### TECHNICAL FIELD

The present disclosure relates to a sensor, a method for producing a sensor and an information processing method. BACKGROUND ART

Patent Literature 1 discloses a sensor. This sensor includes a substrate, multiple light-emitting elements, a light-receiving element, and a synchronous detection circuit. The light-emitting elements are disposed in different positions on the substrate and are configured to emit a light ray using mutually orthogonal first and second modulation signals. The light-receiving element is disposed inside the substrate and is configured to receive an external light ray through a pinhole and to generate a photocurrent. The synchronous detection circuit is configured to detect the phase of a specific component of the photocurrent. The specific component is a component originating from a composite reflected light ray emitted from the light-emitting elements and reflected from an object, and the phase is expressed as a function of the distance to the object. Citation List

### Patent Literature

[Patent Literature 1] Japanese Unexamined Patent Application Publication No. 2020-190552

### SUMMARY OF INVENTION

### Problem Solved by Invention

On the other hand, there is a need for a sensor capable of grasping spatial physical quantities such as the distance with a simpler structure than the prior art disclosed in Patent Literature 1 and with high accuracy.

In view of the above circumstances, the present disclosure provides a sensor with a simpler structure and high accuracy. Solution to Problem

One aspect of the present disclosure provides a sensor for determining an object. This sensor includes multiple light-emitting elements and at least one of light-receiving element(s). The light-emitting elements are disposed in different positions on a substrate. The light-receiving element is disposed on the substrate. The light-receiving element receives one of reflected light rays originating from the light-emitting elements as a main light ray and receives a reflected light ray other than the main light ray as a crosstalk light ray so as to be able to distinguish the crosstalk light ray from the main light ray. The reflected light rays are light rays emitted from the light-emitting elements and reflected from the object. The sensor determines spatial physical quantities related to the reference plane of the sensor and the object on the basis of the distinguishably received main light ray and crosstalk light ray.

According to the present disclosure, a sensor with a simpler structure and high accuracy is realized.

### BRIEF DESCRIPTION OF DRAWINGS

FIG. 1 is a plan view of a sensor 1 according to the present embodiment that mainly shows an overview of the configuration of a detection unit 2.
FIG. 2 is a block diagram of the sensor 1 according to the present embodiment that mainly shows an overview of the configuration of an information processing unit 4.
FIG. 3 is a block diagram showing functions implemented by a processor 43 or the like of the sensor 1.
FIG. 4 is a schematic diagram showing the configuration of the neural network of a trained model 5.
FIG. 5 is an activity diagram showing the flow of a process of determining an object Ob using the sensor 1.
FIGS. 6A to 6D are schematic diagrams showing the timings at which the light-emitting elements 31 emit a light ray and the aspect in which light-receiving elements 32 receive the light ray, and the light-emitting elements 31 emit a light ray in the order of FIG. 6A, FIG. 6B, FIG. 6C and FIG. 6D.
FIG. 7 is a schematic front view showing the configuration of a sensor 1 according to a modification. Description of Embodiments

### [Embodiment]

Now, an embodiment of the present disclosure will be described with reference to the drawings. Various features described in the embodiment below can be combined with each other.

A program to implement software that appears in the present embodiment may be provided as a computer-readable non-transitory storage medium or may be provided by downloading it from an external server, or the program may be provided such that it is run on an external computer and its functions are implemented on a client terminal (so-called cloud computing).

The term "unit" in the present embodiment includes, for example, a combination of hardware resources implemented by a circuit in a broad sense and software information processing that can be specifically implemented by the hardware resources. Various types of information handled in the present embodiment are represented by, for example, the physical values of signal values representing voltages or currents, high or low signal values as binary bit sets consisting of 0s or 1s, or quantum superpositions (so-called qubits) and can be communicated and subjected to a calculation on a circuit in a broad sense.

The term "circuit in a broad sense" refers to a circuit implemented by combining at least a circuit, circuitry, a processor, memory, and the like appropriately.
That is, the term "circuit in a broad sense" includes an application-specific integrated circuit (ASIC), a programmable logic device (e.g., a simple programmable logic device (SPLD), a complex programmable logic device (CPLD), a field programmable gate array (FPGA)), and the like.

### 1. Hardware Configuration

The hardware configuration of a sensor 1 according to the present embodiment will be described in this section. The sensor 1 is a sensor for determining an object Ob. More specifically, the sensor 1 is configured to determine spatial physical quantities related to the reference plane of the sensor 1 and the object Ob. Preferably, the spatial physical quantities here include at least the distance d between the reference plane and the object Ob and the angles θ and φ of the object Ob with respect to the reference plane (parameters representing a three-dimensional posture). Particularly preferably, the distance d is a close range. For example, the distance is 50 mm or less. Specifically, for example, the distance is 50, 49, 48, 47, 46, 45, 44, 43, 42, 41, 40, 39, 38, 37, 36, 35, 34, 33, 32, 31, 30, 29, 28, 27, 26, 25, 24, 23, 22, 21, 20, 19, 18, 17, 16, 15, 14, 13, 12, 11, 10, 9, 8, 7, 6, 5, 4, 3, 2, 1, or 0 mm and may be in the range between any two of the values illustrated above. The sensor 1 thus configured is able to determine the distance d to the object Ob and the angles θ and φ and can be used in various scenes such as picking or inspection of objects. _
The sensor 1 thus configured is also able to accurately grasp the object Ob located at a very short distance.

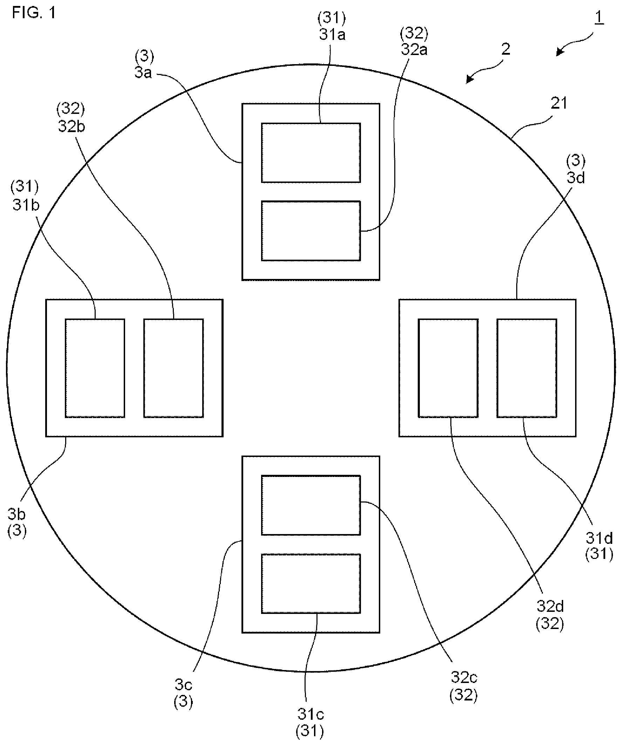

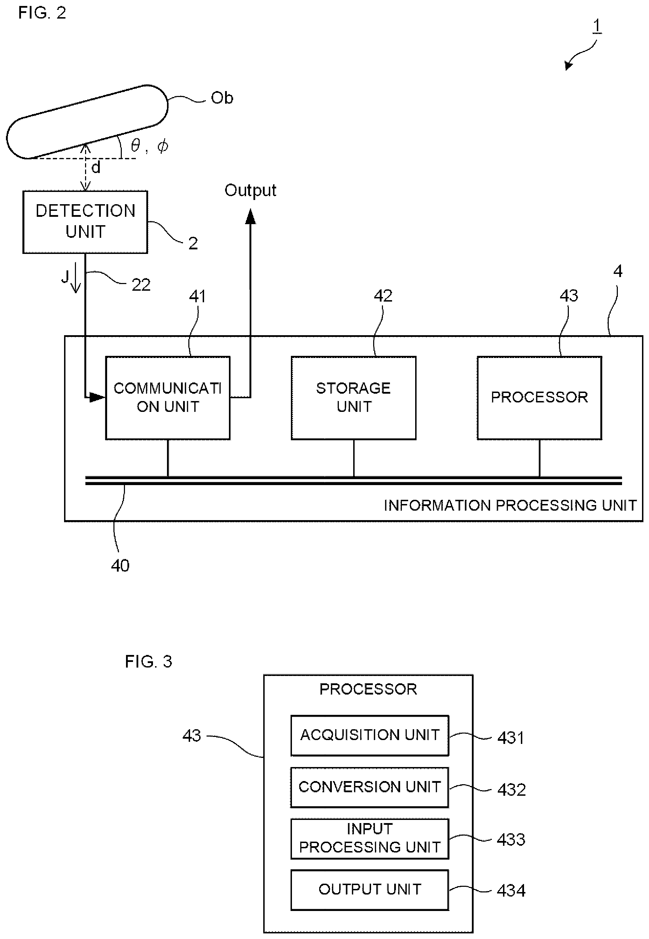

FIG. 1 is a plan view of the sensor 1 according to the present embodiment that mainly shows an overview of the configuration of a detection unit 2. FIG. 2 is a block diagram of the sensor 1 according to the present embodiment that mainly shows an overview of the configuration of an information processing unit 4. As shown in FIGS. 1 and 2, the sensor 1 mainly includes the detection unit 2 and information processing unit 4.

### 1.1 Detection Unit 2

First, the detection unit 2 will be described. As shown in FIGS. 1 and 2, the detection unit 2 includes a substrate 21, multiple light-receiving/emitting blocks 3 disposed on the substrate 21, and an AI input unit 22 connected to the information processing unit 4. The respective components will be further described below.

### (Substrate 21)

The substrate 21 constitutes the housing of the sensor 1. In the present embodiment, the substrate 21 has, for example, an approximately circular shape and is formed as a flat plate. However, this is only illustrative and is not limiting. Preferably, the substrate 21 is made of, for example, a material that is black and lackluster and has low reflectivity. The substrate 21 has the light-receiving/emitting blocks 3 thereon.

### (Light-receiving/emitting Block 3)

As shown in FIG. 1, the multiple light-receiving/emitting blocks 3 are disposed on the substrate 21. A light-emitting element(s) 31 and a light-receiving element(s) 32 are disposed in each light-receiving/emitting block 3. In the present embodiment, one light-emitting element 31 and one light-receiving element 32 are disposed in one light-receiving/emitting block 3. In other words, the light-receiving element 32 and the corresponding light-emitting element 31 are adjacent to each other to form the light-receiving/emitting block 3. The multiple light-receiving/emitting blocks 3 are disposed on the substrate 21.

The number of light-emitting elements 31 is preferably 2 to 30, more preferably 2 to 10, and most preferably 2 to 4. Specifically, for example, the number of light-emitting elements 31 may be 2, 3, 4, 5, 6, 7, 8, 9, 10, 11, 12, 13, 14, 15, 16, 17, 18, 19, 20, 21, 22, 23, 24, 25, 26, 27, 28, 29, or 30 and may be in the range between any two of the numbers illustrated above.

The number of light-receiving/emitting blocks 3 is preferably two or more, more preferably three or more. In the present embodiment, four light-receiving/emitting blocks 3a, 3b, 3c, and 3d are provided. As shown in FIG. 1, more preferably, the light-receiving/emitting blocks 3 are disposed annularly and at equal intervals on the substrate 21. In other words, the light-receiving/emitting blocks 3 are disposed symmetrically with respect to the substrate 21. Specifically, a light-emitting element 31a and a light-receiving element 32a are disposed in the light-receiving/emitting block 3a, a light-emitting element 31b and a light-receiving element 32b are disposed in the light-receiving/emitting block 3b, a light-emitting element 31c and a light-receiving element 32c are disposed in the light-receiving/emitting block 3c, and a light-emitting element 31d and a light-receiving element 32d are disposed in the light-receiving/emitting block 3d. Such a configuration makes photocurrents J (an example of electrical physical quantities) based on the multiple light-receiving elements 32 symmetrical and further increases the accuracy of the sensor 1. In other words, the light-receiving elements 32 are the same in number as the light-emitting elements 31 and are associated with the light-emitting elements 31 one-to-one. Such a configuration allows the sensor 1 to obtain the photocurrents J based on the multiple light-receiving elements 32 and further increases the accuracy of the sensor 1. The photocurrents J will be described later.

As shown in FIG. 1, the light-emitting elements 31 are disposed in different positions on the substrate 21. The light-emitting elements 31 only have to be elements that apply a diffuse light ray to the object Ob. For example, the light-emitting elements 31 are light emitting diodes (LED) and, preferably, infrared LEDs that emit an infrared light ray that is invisible to humans and harmless to human bodies. Of course, the light-emitting elements 31 are not limited to infrared LEDs and may be red LEDs, green LEDs, or blue LEDs. By connecting the positive side of a power supply (not shown) to the anode side of the light-emitting elements 31 that are light emitting diodes as described above, currents flow, resulting in application of diffuse light rays of a specific frequency to the object Ob.

As shown in FIG. 1, the light-receiving elements 32 are disposed on the substrate 21. The light-receiving elements 32 are elements that detect received light rays and in turn generate photocurrents J, which are an example of electrical physical quantities. In other words, the light-receiving elements 32 are configured to output photocurrents J corresponding to the illuminance of received light rays. Preferably, the illuminance of the light rays and the photocurrents J have linear characteristics. Major examples of the light-receiving elements 32 include phototubes, photomultiplier tubes, phototransistors using the internal photoelectric effect of semiconductors, photodiodes, avalanche photodiodes, photoconductive cells, image sensors, and the like. Preferably, the light-receiving elements 32 are photodiodes with wide directivity, or phototransistors obtained by combining such photodiodes and amplifiers.

Each light-receiving element 32 receives, as a main light ray, a reflected light ray L emitted from a light-emitting element 31 belonging to the same light-receiving/emitting block 3 and reflected from the object Ob. The light-receiving element 32 also receives, as crosstalk light rays, reflected light rays L emitted from light-emitting elements 31 belonging to adjacent light-receiving/emitting blocks 3 and reflected from the object Ob. For example, the light-receiving element 32a receives, as a main light ray, a reflected light ray L originating from the light-emitting element 31a and receives, as crosstalk light rays, reflected light rays L originating from the light-emitting elements 31b and 31d. In other words, the light-receiving elements 32 are each configured to receive one of the reflected light rays L originating from the light-emitting elements 31 as a main light ray as well as receive the reflected light rays L other than the main light ray as crosstalk light rays so as to be able to distinguish the crosstalk light rays from the main light ray and to generate photocurrents J (an example of electrical physical quantities) corresponding to the reflected light rays L. The reflected light rays L here are light rays emitted from the light-emitting elements 31 and reflected from the object Ob. The spatial physical quantities related to the reference plane of the sensor 1 and the object Ob are determined on the basis of the photocurrents J based on the main light rays and crosstalk light rays received distinguishably as described above. This will be described in more detail later.

### (AI Input Unit 22)

The AI input unit 22 inputs the values of the photocurrents J or calculated values based on the photocurrents J as input parameters to a trained model 5 stored in the storage unit 42 of the information processing unit 4 (to be discussed later). That is, the AI input unit 22 serves as a conductor from the light-receiving elements 32 of the detection unit 2 to the information processing unit 4. The photocurrents J outputted from the light-receiving elements 32 are inputted to the trained model 5 stored in the storage unit 42 through the AI input unit 22 and a communication unit 41 (to be discussed later).

### 1.2 Information Processing Unit 4

Next, the information processing unit 4 will be described. The information processing unit 4 is a processing circuit configured to control the operation of the sensor 1, for example, a microcontroller. The information processing unit 4 includes the communication unit 41, the storage unit 42, and a processor 43. These components are electrically connected through a communication bus 40 in the information processing unit 4. The respective components will be further described.

The communication unit 41 is configured to transmit various electrical signals from the information processing unit 4 to external components. The communication unit 41 is also configured to receive various electrical signals from the external components to the information processing unit 4. Specifically, the communication unit 41 receives the photocurrents J outputted from the AI input unit 22 of the detection unit 2. The communication unit 41 outputs spatial physical quantities estimated based on the trained model 5. Preferably, the communication unit 41 has a network communication function. Thus, various information can be communicated between the sensor 1 and external devices through a network such as the Internet.

The storage unit 42 is storing various information defined by the foregoing description. The storage unit 42 can be implemented, for example, as a storage device such as a solid-state drive (SSD) that stores various programs or the like related to the sensor 1 executed by the processor 43, or as memory such as random access memory (RAM) that stores temporarily required information (arguments, arrays, etc.) related to program calculations. The storage unit 42 is storing various programs, variables, and the like related to the sensor 1 executed by the processor 43. Particularly, in the present embodiment, the storage unit 42 is storing the trained model 5.

The processor 43 is, for example, a central processing unit (CPU) (not shown). The processor 43 implements various functions related to the sensor 1 by reading a predetermined program stored in the storage unit 42. That is, when the processor 43, which is an example of hardware, specifically performs information processing using the software stored in the storage unit 42, functional units of the processor 43 are implemented. These will be described in more detail in the next section. Note that the processor 43 does not have to be a single processor and function-specific multiple processors 43 may be provided. Or, a combination of these may be used.

The sensor 1 thus configured is singly able to determine the spatial physical quantities of the object Ob without using a separate computer or the like.

### 2. Functional Configuration

The functional configuration of the present embodiment will be described in this section. As described above, when the processor 43, which is an example of hardware, specifically performs information processing using the software stored in the storage unit 42, the functional units of the processor 43 are implemented.

FIG. 3 is a block diagram showing functions implemented by the processor 43 or the like of the sensor 1. Specifically, the processor 43 includes an acquisition unit 431, a conversion unit 432, an input processing unit 433, and an output unit 434 as functional units.

The acquisition unit 431 is configured to acquire, as an acquisition step, various information received from the outside through the communication unit 41 or previously stored in the storage 42. For example, the acquisition unit 431 acquires the photocurrents J outputted from the light-receiving elements 32.

The conversion unit 432 is configured to convert, as a conversion step, the various information acquired by the acquisition unit 431 by performing a predetermined calculation on the information. For example, the conversion unit 432 may convert information by performing a predetermined calculation on the values of the multiple photocurrents J acquired by the acquisition unit 431.

The input processing unit 433 is configured to input, as an input processing step, input parameters to the trained model 5 stored in the storage unit 42.

The output unit 434 is configured to output, as an output step, various information. Specifically, the output unit 434 may output spatial physical quantities estimated based on the trained model 5, for example, the distance d and the angles θ and φ.

### 3. Configuration of Trained Model 5

The trained model 5 stored in the storage unit 42 will be described in this section. The trained model 5 is a model previously machine-trained with the relationships between the spatial physical quantities related to the reference plane of the sensor 1 and the object Ob and the values of the photocurrents J or the calculated values. Preferably, with respect to the material of each object Ob, the trained model 5 is trained with the relationships between the values of the photocurrents J or the predetermined calculated values and the spatial physical quantities related to the object Ob and the reference plane of the sensor 1. Specific examples of the object Ob include an object Ob made of a mirror-reflective material, an object Ob made of a diffuse-reflective white material, an object Ob consisting of a green, hard PVC board, an object Ob consisting of a yellow, hard PVC board, an object Ob consisting of a blue, hard PVC board, an object Ob consisting of an aluminum board, an object Ob consisting of a rough-finished aluminum board, an object Ob consisting of a wire mesh, an object Ob consisting of a leather product, and the like. The sensor 1 thus configured is able to make a robust determination even with respect to an object Ob with respect to which it has been difficult to make a determination, such as an object Ob with a mirror surface, a transparent object Ob, or an object Ob with an uneven surface.

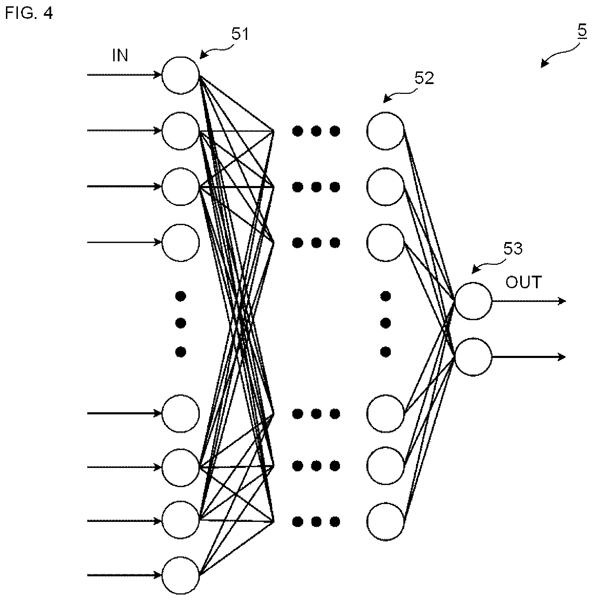

FIG. 4 is a schematic diagram showing the configuration of the neural network of the trained model 5. As shown in FIG. 4, the trained model 5 includes an input layer 51, an intermediate layer 52 consisting of at least one layer, and an output layer 53.

The input layer 51 receives input of, as input signals, the values of the photocurrents J outputted from the light-receiving elements 32 or calculated values obtained by performing a predetermined calculation on the photocurrents J. While FIG. 4 shows at least eight input terminals (hollow circles in the figure) as the input layer 51, this is only illustrative and is not limiting.

The intermediate layer 52 is a layer in which the neural network performs main processing and may consist of any number of layers. Multiple neurons (hollow circles in the figure) in each layer are coupled to multiple neurons in the next layer. For example, one neuron in the first layer of the intermediate layer 52 receives weighted (loaded) input from each terminal in the input layer 51 and transmits the weighted calculation result to each neuron in the second layer of the intermediate layer 52. Then, one neuron in the second layer of the intermediate layer 52 receives the weighted input from each neuron in the first layer of the intermediate layer 52 and transmits the weighted calculation result to each neuron in the third layer of the intermediate layer 52. Such a process is sequentially performed in accordance with the number of layers of the intermediate layer 52.

The output layer 53 is a layer that outputs the output results of the trained model 5. While two output terminals (hollow circles in the figure) are illustrated as the output layer 53 in FIG. 4, this is only illustrative and is not limiting. Preferably, the trained model 5 outputs the distance d and the angles θ and φ as the spatial physical quantities related to the reference plane of the sensor 1 and the object Ob. That is, in relation to the trained model 5, the processor 43 of the information processing unit 4 is configured to input the values of the photocurrents J or calculated values as input parameters to the trained model 5 and to determine the spatial physical quantities on the basis of the output results from the trained model 5.

### 4.Flow of Determination Process including Information Processing Method

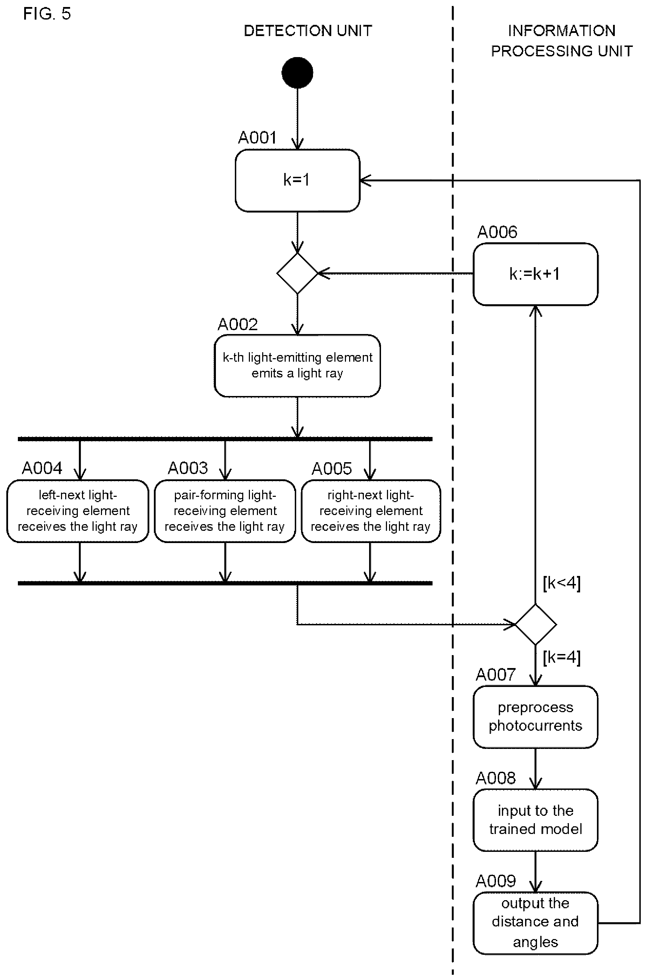

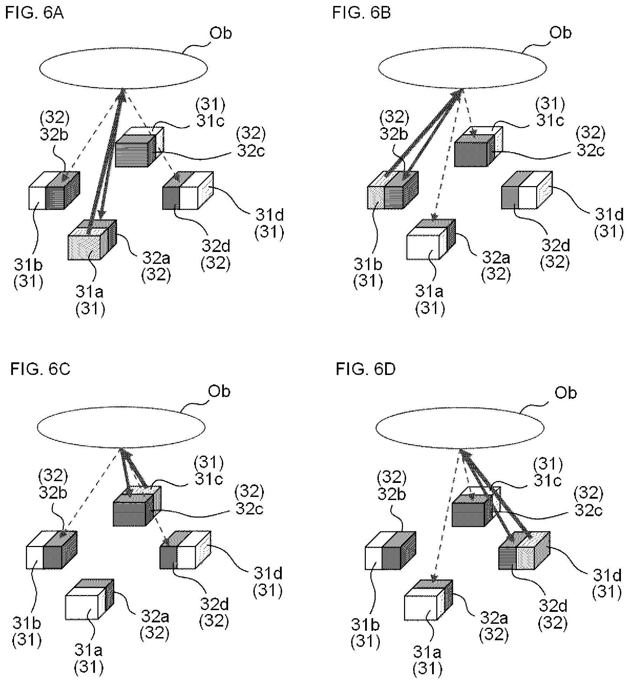

The flow of a process of determining the object Ob using the sensor 1 will be described in this section. FIG. 5 is an activity diagram showing the flow of the process of determining the object Ob using the sensor 1. FIGS. 6A to 6D are schematic diagrams showing the timings at which each light-emitting element 31 emits a light ray and the aspect in which light-receiving elements 32 receive the light ray. The light-emitting elements 31 emit a light ray in the order of FIGS. 6A, 6B, 6C and 6D. The flow of the determination process will be described below with reference to this activity diagram.

In the present embodiment, the sensor 1 includes the four light-receiving/emitting blocks 3, and the light-emitting elements 31 of the light-receiving/emitting blocks 3 emit a light ray at different timings. According to such a configuration, the light-receiving elements 32 are able to easily distinguish the reflected light rays L originating from the light-emitting elements 31 from each other. The light emission of the "k-the (k = 1, 2, 3, 4) light-emitting element 31 will be sequentially described below. That is, the light-emitting elements 31a, 31b, 31c, and 31d periodically emit a light ray at different timings. First, when k=1 (activity A001), the first light-emitting element 31, for example, the light-emitting element 31a shown in FIG. 6A emits a light ray (activity A002).

Then, the light ray emitted from the light-emitting element 31a is reflected from the object Ob, and the resulting reflected light rays L enter multiple light-receiving elements 32. Specifically, the light-receiving element 32a receives the reflected light ray L originating from the light-emitting element 31a as a main light ray (activity A003). The light-receiving element 32a is a light-receiving element 32 forming a pair with the light-emitting element 31a and is located in the light-receiving/emitting block 3a, which is the same light-receiving/emitting block as that of the light-emitting element 31a. The light-receiving element 32b receives the reflected light ray L originating from the light-emitting element 31a as a crosstalk light ray (activity A004). Note that the light-receiving element 32b is a light-receiving element 32 disposed in the light-receiving/emitting block 3b located on the left next to the light-receiving/emitting block 3a in which the light-emitting element 31a is disposed. The light-receiving element 32d receives the reflected light ray L originating from the light-emitting element 31a as a crosstalk light ray (activity A005). Note that the light-receiving element 32d is a light-receiving element 32 disposed in the light-receiving/emitting block 3d located next to the right side of the light-receiving/emitting block 3a in which the light-emitting element 31a is disposed. Then, the light-receiving elements 32a, 32b, and 32d output photocurrents J corresponding to the reflected light rays L received. Then, the acquisition unit 431 of the information processing unit 4 acquires the photocurrents J. In other words, each light-receiving element 32 receives the reflected light ray L originating from the corresponding light-emitting element 31 as a main light ray and receives the reflected light rays L other than the main light ray as crosstalk light rays so as to be able to distinguish the crosstalk light rays from the main light ray.

Then, since k<4, the value of k is incremented (activity A006) and the second light-emitting element 31, for example, the light-emitting element 31b shown in FIG. 6B emits a light ray (activity A002).

Then, the light ray emitted from the light-emitting element 31b is reflected from the object Ob, and the reflected light rays L enter multiple light-receiving elements 32. Specifically, the light-receiving element 32b receives the reflected light ray L originating from the light-emitting element 31b as a main light ray (activity A003). The light-receiving element 32c receives the reflected light ray L originating from the light-emitting element 31b as a crosstalk light ray (activity A004). The light-receiving element 32a receives the reflected light ray L originating from the light-emitting element 31b as a crosstalk light ray (activity A005). Then, the light-receiving elements 32b, 32c, and 32a output photocurrents J corresponding to the reflected light rays L received. Then, the acquisition unit 431 of the information processing unit 4 acquires the photocurrents J.

Then, since k < 4, the value of k is incremented (activity A006) and the third light-emitting element 31, for example, the light-emitting element 31c shown in FIG. 6B emits a light ray (activity A002).

Then, the light ray emitted from the light-emitting element 31c is reflected from the object Ob, and the reflected light rays L enter multiple light-receiving elements 32. Specifically, the light-receiving element 32c receives the reflected light ray L originating from the light-emitting element 31c as a main light ray (activity A003). The light-receiving element 32d receives the reflected light ray L originating from the light-emitting element 31c as a crosstalk light ray (activity A004). The light-receiving element 32b receives the reflected light ray L originating from the light-emitting element 31c as a crosstalk light ray (activity A005). Then, the light-receiving elements 32c, 32d, and 32b output photocurrents J corresponding to the reflected light rays L received. Then, the acquisition unit 431 of the information processing unit 4 acquires the photocurrents J.

Then, since k<4, the value of k is incremented (activity A006) and the fourth light-emitting element 31, for example, the light-emitting element 31d shown in FIG. 6D emits a light ray (activity A002).

Then, the light emitted from the light-emitting element 31d is reflected from the object Ob, and the reflected light rays L enter multiple light-receiving elements 32. Specifically, the light-receiving element 32d receives the reflected light ray L originating from the light-emitting element 31d as a main light ray (activity A003). The light-receiving element 32a receives the reflected light ray L originating from the light-emitting element 31d as a crosstalk light ray (activity A004). The light-receiving element 32c receives the reflected light ray L originating from the light-emitting element 31d as a crosstalk light ray (activity A005). Then, the light-receiving elements 32d, 32a, and 32c output photocurrents J corresponding to the reflected light rays L received. Then, the acquisition unit 431 of the information processing unit 4 acquires the photocurrents J. As seen above, the four-time light emission leads to the acquisition of the 12 channels of photocurrents J.

Since k is 4 this time, activities A007 to A009 are performed.
Specifically, first, the conversion unit 432 of the information processing unit 4 performs preprocessing of converting the photocurrents J acquired by the acquisition unit 431 into predetermined calculated values (activity A007). The predetermined calculated values may be any values as long as they are values obtained by performing a calculation on the photocurrents J. The number of channels of these calculated values may be the same as or smaller than the number (for example, 12) of channels of the photocurrents J.

Then, the input processing unit 433 of the information processing unit 4 inputs the calculated values obtained in activity A007 as input parameters to the trained model 5 (activity A008).

Finally, the output unit 434 of the information processing unit 4 outputs the spatial physical quantities estimated by the trained model 5 and, in the present embodiment, the distance d and the angles θ and φ (activity A009). The above process is continuously performed as long as the sensor 1 is operating. Thus, the distance d and the angles θ and φ are sequentially determined in accordance with the operating frequency of the sensor 1. The time from the light emission of the first light-emitting element 31 until the distance d and the angles θ and φ are determined by estimation is preferably 100 ms or less, more preferably 10 ms or less, even more preferably 1 ms or less, still more preferably 0.7 ms or less. Specifically, for example, the time until the determination may be 100, 95, 90, 85, 80, 75, 70, 65, 60, 55, 50, 45, 40, 35, 30, 25, 20, 15, 10, 9, 8, 7, 6, 5, 4, 3, 2, 1, 0.9, 0.8, 0.7, 0.6, 0.5, 0.4, 0.3, 0.2, or 0.1 milliseconds and may be in the range between any two of the values illustrated above. That is, the time from the light emission of the k-th light-emitting element 31 to the light emission of the (k+1)-th light-emitting element 31 is preferably 1/4 or less of the above determination time. More generally, the time from the light emission of the k-th light-emitting element 31 to the light emission of the (k+1)-th light-emitting element 31 is preferably equal to or less than a time obtained by dividing "the time from the light emission of the first light-emitting element 31 until the distance d and the angles θ and φ are determined by estimation" by "the number of light-emitting elements 31".

The above is summarized as follows: the sensor 1 according to the present embodiment is a sensor for determining the object Ob; the sensor 1 includes the multiple light-emitting elements 31, the light-receiving element(s) 32, and the AI input unit 22; the light-emitting elements 31 are disposed in different positions on the substrate 21; the light-receiving element(s) 32 is disposed on the substrate 21; the light-receiving element(s) 32 is configured to receive one of the reflected light rays L originating from the light-emitting elements 31 as a main light ray and to receive the reflected light ray(s) L other than the main light ray as a crosstalk light ray(s) so as to be able to distinguish the crosstalk light ray(s) from the main light ray; the reflected light rays L are light rays emitted from the light-emitting elements 31 and reflected from the object Ob; and the sensor 1 determines the spatial physical quantities related to the reference plane of the sensor 1 and the object Ob on the basis of the distinguishably received main light ray and crosstalk light ray(s).

According to another aspect, this information processing method includes an acquisition step of acquiring the photocurrents J (an example of electrical physical quantities) outputted from the light-receiving elements 32, an input processing step of inputting the values of the photocurrents J or calculated values based on the photocurrents J as input parameters to the trained model 5, the trained model 5 being a model previously machine-trained with the relationships between the spatial physical quantities related to the reference plane of the sensor 1 and the object Ob and the values of the photocurrents J or the calculated values, and an output step of outputting the spatial physical quantities by estimation on the basis of the trained model 5.

According to such a configuration, a sensor with a simpler structure and high accuracy is realized. In particular, by using not only the reflected light ray L related to the associated light-emitting element and light-receiving element such as the light-emitting element 31a and the light-receiving element 32a but also the crosstalk light rays, which have been considered as disturbances, as input parameters for determination, more multilateral information is obtained, resulting in an increase in determination accuracy.

### [Others]

Further creativity may be applied to the sensor 1 according to the present embodiment.

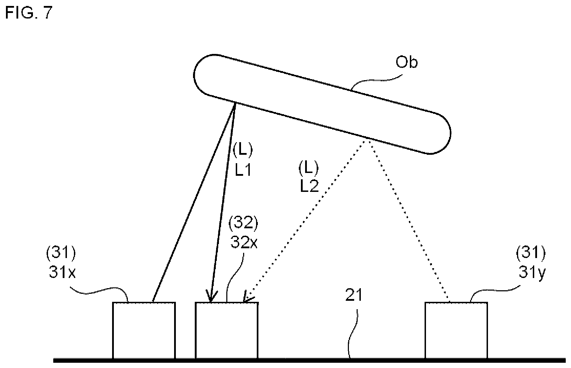

The light-emitting elements 31 and light-receiving elements 32 do not have to be disposed one-on-one. FIG. 7 is a schematic front view showing the configuration of a sensor 1 according to a modification. The sensor 1 according to the modification includes two light-emitting elements 31x, 31y and one light-receiving element 32x as minimum components. A light ray emitted from the light-emitting element 31x is reflected from an object Ob, and the reflected light ray L1 (an example of a main light ray) is received by the light-receiving element 32x. A light ray emitted from the light-emitting element 31y is reflected from the object Ob, and the reflected light ray L2 (an example of a crosstalk light ray) is received by the light-receiving element 32x. The sensor 1 thus configured is also able to determine the distance d and the angle θ (an angle in one direction) by estimation using a trained model 5 that has previously been machine-trained.

While the case in which the light-emitting elements 31 and light-receiving elements 32 are included in the light-receiving/emitting blocks 3 one-on-one and the light-receiving/emitting blocks 3 are disposed annularly and at equal intervals on the substrate 21 is illustrated in the above embodiment, the light-emitting elements 31 and light-receiving element 32 may be disposed on the substrate 21 with no regularity. In such a case also, the distance d and the angles θ and φ are determined by estimation by preparing the trained model 5 that has previously been machine-trained.

While the sensor 1 has been described as including the detection unit 2 and information processing unit 4, the sensor 1 may include the detection unit 2 alone and a computer (not shown) connected to the detection unit 2 may output determination results. In such a case, it is preferable that the trained model 5 be stored in a storage unit (not shown) included in the computer (not shown) and a processor (not shown) perform an input process to the trained model 5. The sensor 1 and the computer (not shown) may be connected in any manner and may be directly connected using a conductor, or the sensor 1 may be provided with a wireless communication function so that the sensor 1 and the computer (not shown) can be connected through wireless communication. In such a case, one computer (not shown) may correspond to multiple sensors 1.

The above sensor 1 may be produced using a predetermined production method. Preferably, this production method includes the step of disposing the multiple light-emitting elements 31 and at least one of light-receiving element(s) 32 on the substrate 21. For example, this production method may include disposing the multiple light-emitting elements 31 and then the light-receiving element 32 on the substrate 21 and then connecting the output of the light-receiving element 32 and the information processing unit 4 such as a microcontroller. According to such a method, a sensor with a simpler structure and high accuracy is produced.

In the above embodiment, the light-emitting elements 31 emit light rays at different timings so that the resulting photocurrents J are distinguished from each other. However, instead of the different timings, the light-emitting elements 31 may blink at different frequencies or emit light rays of different wavelengths so that the resulting photocurrents J are distinguished from each other.

Not only the light-receiving elements 32 adjacent in the left-right direction but also the opposite light-receiving element 32 may receive a crosstalk light ray. That is, light-receiving elements 32 that receive a crosstalk light ray may be freely positioned in accordance with the number of light-receiving/emitting blocks 3.

The trained model 5 may be a one-dimensional convolutional network or a two-dimensional convolutional network in place of the neural network.

The electrical physical quantities generated by the light-receiving elements 32 are not limited to the photocurrents J and may be, for example, voltages.

The present disclosure may be provided in aspects below.
(1) A sensor for determining an object, comprising: a plurality of light-emitting elements disposed in different positions on a substrate; and at least one of light-receiving element(s) disposed on the substrate, configured to: receive, as a main light ray, one of reflected light rays originating from the light-emitting elements, and receive, as a crosstalk light ray distinguishable from the main light ray, a reflected light ray other than the main light ray, wherein the reflected light rays are light rays emitted from the light-emitting elements and reflected from the object; wherein the sensor determines spatial physical quantities related to a reference plane of the sensor and the object on the basis of the distinguishably received main light ray and crosstalk light ray.
(2) The sensor according to (1), wherein the spatial physical quantities include at least a distance between the reference plane and the object and an angle of the object with respect to the reference plane.
(3) The sensor according to (2), wherein the distance is 50 mm or less.
(4) The sensor according to any one of (1) to (3), wherein the light-receiving elements are equal in number to to the light-emitting elements and are associated with the light-emitting elements one-to-one, and are configured to receive, as the main light ray, the reflected light ray originating from the associated light-emitting elements and to receive, as the crosstalk light ray, the reflected light ray other than the main light ray so as to be able to distinguish the crosstalk light ray from the main light ray.
(5) The sensor according to (4), wherein: the light-receiving element and the associated light-emitting elements are adjacent to each other to form a plurality of light-receiving/emitting blocks, and the light-receiving/emitting blocks are disposed on the substrate.
(6) The sensor according to (5), wherein the light-receiving/emitting blocks are disposed annularly and at equal intervals on the substrate.
(7) The sensor according to any one of (1) to (6), wherein the number of the light-emitting elements is 2 to 4.
(8) The sensor according to any one of (1) to (7), wherein the light-emitting elements emit a light ray at different timings.
(9) The sensor according to any one of (1) to (8), wherein: the light-receiving element is configured to generate electrical physical quantities corresponding to the reflected light rays, and the sensor determines the spatial physical quantities related to the reference plane of the sensor and the object on the basis of the electrical physical quantities based on the distinguishably received main light ray and crosstalk light ray.
(10) The sensor according to (9), further comprising an AI input unit configured to input values of the electrical physical quantities or calculated values based on the electrical physical quantities as input parameters to a trained model, the trained model being a model previously machine-trained with relationships between the spatial physical quantities related to the reference plane of the sensor and the object and the values of the electrical physical quantities or the calculated values.
(11) The sensor according to (10), further comprising: a storage unit storing the trained model, and a processor configured to input the values of the electrical physical quantities or the calculated values as the input parameters to the trained model and to determine the spatial physical quantities on the basis of output results from the trained model.
(12) The sensor according to any one of (1) to (11), wherein the light-receiving element is a light-receiving element having wide directivity.
(13) A method for producing a sensor, comprising a step of disposing a plurality of light-emitting elements and at least one of light-receiving element(s), wherein the sensor is the sensor described in any one of claims 1 to 12.
(14) An information processing method comprising: an acquisition step of acquiring electrical physical quantities outputted from a light-receiving element; an input processing step of inputting values of the electrical physical quantities or calculated values based on the electrical physical quantities as input parameters to a trained model, the trained model being a model previously machine-trained with relationships between spatial physical quantities related to a reference plane of a sensor and an object and the values of the electrical physical quantities or the calculated values; and an output step of outputting the spatial physical quantities by estimation on the basis of the trained model.

Of course, the present disclosure is not limited thereto.

Finally, while the various embodiments according to the present disclosure have been described above, the embodiments are only illustrative and are not intended to limit the scope of the disclosure. The novel embodiments can be carried out in other various aspects, and various omissions, replacements, or changes can be made thereto without departing from the gist of the disclosure. The embodiments and modifications thereof are included in the scope and gist of the present disclosure, as well as included in the scope of the disclosure set forth in the claims and equivalents thereof.

### List of Reference Signs

1: sensor
2: detection unit
21: substrate
22: AI input unit
3: light-receiving/emitting block
3a: light-receiving/emitting block
3b: light-receiving/emitting block
3c: light-receiving/emitting block
3d: light-receiving/emitting block
31: light-emitting element
31a: light-emitting element
31b: light-emitting element
31c: light-emitting element
31d: light-emitting element
31x: light-emitting element
31y: light-emitting element
32: light-receiving element
32a: light-receiving element
32b: light-receiving element
32c: light-receiving element
32d: light-receiving element
32x: light-receiving element
4: information processing unit
40: communication bus
41: communication unit
42: storage unit
43: processor
431: acquisition unit
432: conversion unit
433: input processing unit
434 output unit
5: trained model
51: input layer
52: intermediate layer
53: output layer
J: photocurrent
L: reflected light
L1: reflected light
L2: reflected light
Ob: object
d: distance
θ: angle
φ: angle

## Claims

1. A sensor for determining an object, comprising:
a plurality of light-emitting elements disposed in different positions on a substrate; and
at least one of light-receiving element(s) disposed on the substrate, configured to:
receive, as a main light ray, one of reflected light rays originating from the light-emitting elements, and
receive, as a crosstalk light ray distinguishable from the main light ray, a reflected light ray other than the main light ray, wherein the reflected light rays are light rays emitted from the light-emitting elements and reflected from the object;
wherein the sensor determines spatial physical quantities related to a reference plane of the sensor and the object on the basis of the distinguishably received main light ray and crosstalk light ray.

2. The sensor according to claim 1, wherein the spatial physical quantities include at least a distance between the reference plane and the object and an angle of the object with respect to the reference plane.

3. The sensor according to claim 2, wherein the distance is 50 mm or less.

4. The sensor according to any one of claims 1 to 3, wherein
the light-receiving elements
are equal in number to to the light-emitting elements and are associated with the light-emitting elements one-to-one, and
are configured to receive, as the main light ray, the reflected light ray originating from the associated light-emitting elements and to receive, as the crosstalk light ray, the reflected light ray other than the main light ray so as to be able to distinguish the crosstalk light ray from the main light ray.

5. The sensor according to claim 4, wherein:
the light-receiving element and the associated light-emitting elements are adjacent to each other to form a plurality of light-receiving/emitting blocks, and
the light-receiving/emitting blocks are disposed on the substrate.

6. The sensor according to claim 5, wherein the light-receiving/emitting blocks are disposed annularly and at equal intervals on the substrate.

7. The sensor according to any one of claims 1 to 6, wherein the number of the light-emitting elements is 2 to 4.

8. The sensor according to any one of claims 1 to 7, wherein the light-emitting elements emit a light ray at different timings.

9. The sensor according to any one of claims 1 to 8, wherein:
the light-receiving element is configured to generate electrical physical quantities corresponding to the reflected light rays, and
the sensor determines the spatial physical quantities related to the reference plane of the sensor and the object on the basis of the electrical physical quantities based on the distinguishably received main light ray and crosstalk light ray.

10. The sensor according to claim 9, further comprising an AI input unit configured to input values of the electrical physical quantities or calculated values based on the electrical physical quantities as input parameters to a trained model, the trained model being a model previously machine-trained with relationships between the spatial physical quantities related to the reference plane of the sensor and the object and the values of the electrical physical quantities or the calculated values.

11. The sensor according to claim 10, further comprising:
a storage unit storing the trained model, and
a processor configured to input the values of the electrical physical quantities or the calculated values as the input parameters to the trained model and to determine the spatial physical quantities on the basis of output results from the trained model.

12. The sensor according to any one of claims 1 to 11, wherein the light-receiving element is a light-receiving element having wide directivity.

13. A method for producing a sensor, comprising a step of disposing a plurality of light-emitting elements and at least one of light-receiving element(s), wherein the sensor is the sensor described in any one of claims 1 to 12.

14. An information processing method comprising:
an acquisition step of acquiring electrical physical quantities outputted from a light-receiving element;
an input processing step of inputting values of the electrical physical quantities or calculated values based on the electrical physical quantities as input parameters to a trained model, the trained model being a model previously machine-trained with relationships between spatial physical quantities related to a reference plane of a sensor and an object and the values of the electrical physical quantities or the calculated values; and
an output step of outputting the spatial physical quantities by estimation on the basis of the trained model.
